# EUROPÄISCHE PATENTSCHRIFT

(11) **EP 2 762 269 B1**
(45) Veröffentlichungstag und Bekanntmachung des Hinweises auf die Patenterteilung: **28.12.2016**
(21) Anmeldenummer: 14151114.7
(22) Anmeldetag: 14.01.2014
(51) Int. Cl.: B23Q 17/00, B23Q 17/24, H01P 3/127, G01B 7/14, H01P 7/06, H03K 17/945

(54) **Vorrichtung zur Überwachung der Lage eines Werkzeugs oder Werkzeugträgers an einer Arbeitsspindel**
Device for monitoring the location of a tool or tool holder on a work spindle
Dispositif de surveillance de la position d'un objet ou d'un porte-outil sur un arbre moteur

(30) Priorität: 31.01.2013 DE 102013100975
(43) Veröffentlichungstag der Anmeldung: 06.08.2014
(73) Patentinhaber: Ott-Jakob Spanntechnik GmbH, 87663 Lengenwang (DE)
(72) Erfinder: Bonerz, Stefan, 87616 Marktoberdorf (DE); Greif, Josef, 87654 Friesenried (DE)
(74) Vertreter: Charrier Rapp & Liebau

(56) Entgegenhaltungen:
- EP-A1- 1 424 746
- EP-A1- 1 603 187
- EP-A2- 0 806 680
- WO-A1-2008/040601
- DE-A1-102009 005 745
- US-A- 3 157 847
- US-A- 4 564 826
- US-A1- 2002 101 307
- US-A1- 2005 280 549
- US-A1- 2008 186 113

## Beschreibung

Die Erfindung betrifft eine Vorrichtung zur Überwachung der Lage eines Werkzeugs oder Werkzeugträgers an einer Arbeitsspindel nach dem Oberbegriff des Anspruchs 1.

Während der von modernen numerisch gesteuerten Werkzeugmaschinen vollzogenen Bearbeitungsvorgänge sind häufige schnelle, im Allgemeinen automatisch durchgeführte Werkzeugwechsel notwendig. Die hierfür eingesetzten Spannvorrichtungen sind meistens modular zweiteilig ausgeführt und weisen zueinander korrespondierende Plananlagen auf, die, unterstützt von sehr großen Spannkräften, für einen präzisen und steifen Sitz der Werkzeuge sorgen. Allerdings existiert bei der Kontaktierung der zueinander komplementären Plananlagen ein wesentlicher Störfaktor, der sich notwendigerweise aus den Betriebsbedingungen von spanabhebend bearbeitenden Werkzeugmaschinen ergibt. Sofern das in Form von mitunter sehr feinen Spänen vorhandene abgetragene Material aus dem Wirkbereich der Maschinen nicht vollständig entfernt werden kann, besteht in Zusammenwirken mit den hierfür verwendeten Mitteln, z.B. Bohr- und Schneidemulsionen, die Möglichkeit der Anhaftung von Spänen auf den Plananlagen. Hierdurch ist in den meisten Fällen eine Fehlausrichtung des Werkzeugs und unzureichende Steifigkeit der Einspannung zu erwarten. Sehr feine Späne führen zu kaum bemerkbaren Fehleinspannungen, die aber trotzdem ein unzureichendes Bearbeitungsergebnis zur Folge haben.

Aus der DE 10 2009 005 745 A1 ist eine Überwachungsvorrichtung zur Erkennung solcher Fehleinspannungen bekannt. Die Funktion dieser Überwachungsvorrichtung basiert auf der Ausbreitung eines Radarsignals in einem innerhalb der Arbeitsspindel durch mehrere Bohrungen gebildeten Kanal, der im Betrieb unmittelbar durch eine Plananlagefläche des Werkzeugs oder Werkzeugträgers abgeschlossen wird, wobei der Endbereich des Kanals als Hohlraumresonator ausgebildet ist. Eine fehlerhafte Anlage des Werkzeugs oder Werkzeugträgers an der Werkzeugspannvorrichtung kann anhand eines Radarsignals detektiert werden, das in den Kanal von einem außerhalb der Arbeitsspindel angeordneten Sender eingestrahlt, an dem Werkzeug oder Werkzeugträger reflektiert und durch den Kanal zu dem Sender zurückgeleitet wird. Die Erzielung einer hohen Messgenauigkeit erfordert aber bei dieser Vorrichtung sehr präzise Abmessungen des gesamten Kanals, was einen hohen Fertigungsaufwand verursacht.

Die US 3,157,847 zeigt die Realisierung eines Hohlwellenleiters durch Zusammenfügung von Platten mit in den Oberflächen dieser Platten ausgebildeten Nuten, wobei zwischen den Platten noch zusätzliche Plattenstücke zur Vergrößerung der Höhe des Kanals über die Summe der Tiefen der Nuten hinaus vorgesehen sein können. Alternativ hierzu wird die Beschichtung einer Anordnung aus einem metallischen Substrat und einem darauf angeordneten dielektrischen Streifen mit einem zweiten metallischen Material und anschließender Entfernung des dielektrischen Streifens zur Ausbildung eines Kanals mit metallischen Wänden vorgeschlagen.

Auch die EP 1,424,746 A1 zeigt die Realisierung eines Hohlwellenleiters durch Zusammenfügung von zwei zueinander symmetrischen Platten mit in den einander zugewandten Oberflächen der beiden Platten ausgebildeten Nuten. Die US 2008/0186113 A1 zeigt ein Übergangsstück zur Verbindung eines rechteckigen Hohlwellenleiters mit einem kreisförmigen Hohlwellenleiter. In einer seiner Ausführungsformen beinhaltet dieses Übergangsstück auch die Funktion einer Umlenkung des Mikrowellensignals um 90°. Auch in der US 4,564,826 wird ein Hohlwellenleiter-Adapter mit einer Richtungsänderung von 90° beschrieben. Dieser Adapter ist dazu vorgesehen, ein Mikrowellensignal in eine Antenne, die an der Spitze eines Gittermastes angebracht ist, einzuspeisen.

Die Aufgabe der Erfindung ist es, die aus der vorausgehend genannten Schrift bekannte Überwachungsvorrichtung so zu verbessern, dass sie ohne Abstriche an der Messgenauigkeit einfacher und kostengünstiger herstellbar ist.

Diese Aufgabe wird erfindungsgemäß durch eine Vorrichtung mit den Merkmalen des Anspruchs 1 gelöst. Vorteilhafte Ausgestaltungen sind in den Unteransprüchen angegeben.

Erfindungsgemäß ist bei einer gattungsgemäßen Überwachungsvorrichtung an mindestens einem der zwei Enden eines von einer äußeren Oberfläche der Arbeitsspindel zu dem Werkzeug oder Werkzeugträger führenden Kanals, der einen Pfad für die Ausbreitung eines elektromagnetischen Signals bildet, ein Einsatz angeordnet, welcher die Form eines Abschnitts des Kanals definiert. Hierdurch wird die Herstellung eines solchen Kanals in der Arbeitsspindel erheblich vereinfacht, indem die Abschnitte des Kanals nicht ausschließlich durch hochpräzise materialabtragende Bearbeitungen in der Arbeitsspindel selbst erzeugt werden müssen, sondern von der Arbeitsspindel separate Teile mit entsprechender Genauigkeit hergestellt und dann in die Arbeitsspindel eingefügt werden können.

Der Kanal kann hierbei wahlweise als Hohlwellenleiter ausgeführt sein, wozu der Einsatz aus leitfähigem Material bestehen oder zumindest eine leitfähige innere Oberfläche, welche die Oberfläche des von ihm definierten Abschnitts des Kanals bildet, aufweisen muss, oder er kann zur Aufnahme eines Wellenleiters in Form einer Koaxialleitung vorgesehen sein und entlang eines überwiegenden Teils seiner Länge lediglich als Halterung für die Koaxialleitung dienen, ohne selbst die Wellenausbreitung elektromagnetisch zu führen.

Besonders vorteilhaft ist im Fall der Notwendigkeit einer Richtungsänderung des Kanals in seinem Verlauf die Ausführung desjenigen Abschnitts, in dem die Richtungsänderung erfolgt, in einem Einsatz, da eine Richtungsänderung in einem elektromagnetischen Wellenleiter eine Reflexionen verursachende Störung darstellt und eine reflexionsminimierende Gestaltung eines Kanalabschnitts mit einer Richtungsänderung an einem separaten Teil wesentlich leichter ausführbar ist als durch eine materialabtragende Bearbeitung in Inneren der Arbeitsspindel.

Eine bevorzugte Ausführungsform eines Einsatzes, insbesondere eines solchen, der einen Abschnitt des Kanals mit einer Richtungsänderung enthält, besteht aus zwei Segmenten, die sich in einer Ebene in flächigem Kontakt miteinander befinden und zueinander symmetrische Nuten enthalten, welche nach der Zusammenfügung der Segmente zusammen den Kanalabschnitt in dem Einsatz bilden. Die Richtungsänderung kann in diesem Fall durch eine entsprechende Richtungsänderung der beiden Nuten, die jeweils an einer Oberfläche eines Segments aus diesem herausgearbeitet, insbesondere herausgefräst werden können, mit hoher Genauigkeit ausgeführt werden.

Alternativ kann ein Einsatz, insbesondere ein solcher, der einen Abschnitt des Kanals mit einer Richtungsänderung enthält, aus einem Hauptteil mit zwei sich schneidenden Durchgangsbohrungen unterschiedlicher Richtungen, die jeweils Kanalabschnitte bilden und deren Schnittbereich sich zumindest teilweise außerhalb des Hauptteils erstreckt, und einem Abschlussteil bestehen, welches den Schnittbereich der Durchgangsbohrungen nach außen abschließt und dadurch den dritten Kanalabschnitt mit der Richtungsänderung vervollständigt. Besonders vorteilhaft ist diese Ausführungsform, wenn in dem Kanal eine Koaxialleitung angeordnet werden soll, weil das Abschlussteil in diesem Fall einen Winkelstecker enthalten oder insgesamt durch einen Winkelstecker gebildet werden kann, der zwei Abschnitte verschiedener Richtungen dieser Koaxialleitung miteinander verbindet. Bei Verwendung eines Koaxialkabels als Wellenleiter in dem Kanal kann somit bei dieser Ausführungsform zur Realisierung einer Richtungsänderung auf verfügbare fertige Komponenten zurückgegriffen werden.

Auch ein sich bis zu dem Werkzeug oder Werkzeugträger erstreckender Endabschnitt des Kanals, welcher zusammen mit einer Oberfläche des Werkzeugs oder Werkzeugträgers einen Mikrowellenresonator mit einer vom Abstand der Oberfläche des Werkzeugs oder Werkzeugträgers vom Ende des Endabschnitts abhängigen Resonanzfrequenz bildet, kann in einem Einsatz ausgebildet sein, um die Herstellung eines solchen Resonators mit präzisen Abmessungen zu vereinfachen. In diesem Fall ist der Einsatz bevorzugt ein becherförmiger Körper, dessen Rand dem Werkzeug oder Werkzeugträger zugewandt ist und dessen Boden eine Öffnung aufweist, durch welche die Einkopplung eines Mikrowellensignals in den Resonator ermöglicht wird. Indem der Außendurchmesser dieses Körpers größer ist als der Durchmesser des sich an die Öffnung in dem Boden anschließenden Abschnitts des Kanals, ergibt sich ein Anschlag, der eine mechanische Belastung des Einsatzes in axialer Richtung durch das an der gegenüberliegenden Seite anliegende Werkzeug aufnimmt und eine Belastung anderer Komponenten wie insbesondere einer an den Mikrowellenresonator angeschlossenen Koaxialleitung verhindert.

Vorteilhafte elektrische Ankopplungen einer Koaxialleitung an einen durch einen erfindungsgemäßen Einsatz ausgebildeten Mikrowellenresonator sind Gegenstand weiterer Unteransprüche.

Nachfolgend werden Ausführungsbeispiele der Erfindung unter Bezugnahme auf die Zeichnungen beschrieben. In diesen zeigt
- Fig. 1: eine Vorderansicht einer Arbeitsspindel,
- Fig. 2: eine schematische Schnittansicht einer fehlerhaften Werkzeugspannung,
- Fig. 3: eine schematische Längsschnittansicht einer Vorrichtung zur Überwachung der Werkzeugplananlage,
- Fig. 4: eine Detailansicht eines Ausschnitts aus Fig. 3 mit einer ersten Ausführungsform eines erfindungsgemäßen Einsatzes,
- Fig. 5: eine Ansicht eines Ausschnitts aus Fig. 4 von oben gesehen,
- Fig. 6: eine Detailansicht einer zweiten Ausführungsform eines erfindungsgemäßen Einsatzes,
- Fig.7: eine Ansicht eines Ausschnitts aus Fig. 4 mit einer dritten Ausführungsform eines erfindungsgemäßen Einsatzes
- Fig. 8: eine erste Art der Ankopplung einer Koaxialleitung an die dritte Ausführungsform eines erfindungsgemäßen Einsatzes
- Fig. 9: eine zweite Art der Ankopplung einer Koaxialleitung an die dritte Ausführungsform eines erfindungsgemäßen Einsatzes.

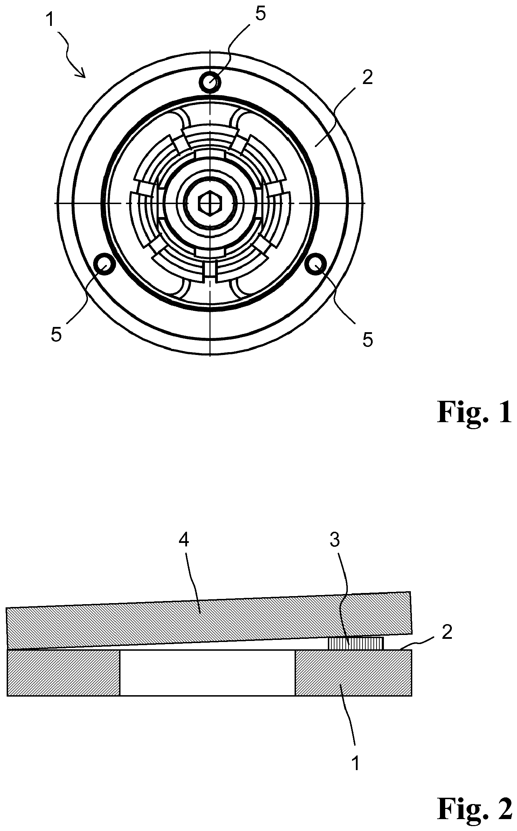

Fig. 1 zeigt die Vorderansicht einer Arbeitsspindel 1, die Bestandteil einer nicht dargestellten Bearbeitungsmaschine, insbesondere einer Werkzeugmaschine ist. Die Arbeitsspindel 1 weist an ihrer Stirnseite eine oder mehrere ebene Anlageflächen 2 auf, an denen ein Werkzeug oder ein Werkzeugträger im gespannten Zustand plan anliegen soll. Im Falle mehrerer separater Anlageflächen 2 liegen diese genau planparallel zueinander in einer einzigen Ebene. Zur Verwendung an der Arbeitsspindel 1 bestimmte Werkzeuge oder Werkzeugträger, wobei letztere ihrerseits verschiedene Werkzeuge aufnehmen können, weisen an ihrer Rückseite ebenfalls entsprechende stirnseitige Anlageflächen auf. Bei einer planen Anlage der werkzeugseitigen bzw. werkzeugträgerseitigen Anlageflächen an der spindelseitigen Anlagefläche 2 verläuft die Längsachse des Werkzeugs bzw. Werkzeugträgers genau parallel zur Längsachse der Arbeitsspindel 1. Die Zentrierung des Werkzeugs bzw. Werkzeugträgers bezüglich der Arbeitsspindel 1 erfolgt durch kegelförmige Auflageflächen im Inneren der Arbeitsspindel 1.

Im Fall einer Verschmutzung einer Anlagefläche 2 ist keine plane Anlage des Werkzeugs oder Werkzeugträgers an der Arbeitsspindel 1 mehr möglich. Insbesondere kann eine solche Verschmutzung durch bei der Bearbeitung eines Werkstücks anfallende Späne erfolgen. Schematisch ist eine solche Situation in Fig. 2 dargestellt. Auf dem rechten Teil der Anlagefläche 2 liegt ein Span 3, der beim Spannen des Werkzeugs 4 an der Arbeitsspindel 1 zwischen dieser und dem Werkzeug 4 eingeklemmt wird und dafür sorgt, dass ein keilförmiger Spalt zwischen beiden besteht. Bei der Bearbeitung eines Werkstücks mit einem solchermaßen schrägstehenden Werkzeug 4 ist kein maßhaltiges Ergebnis, sondern Ausschuss zu erwarten.

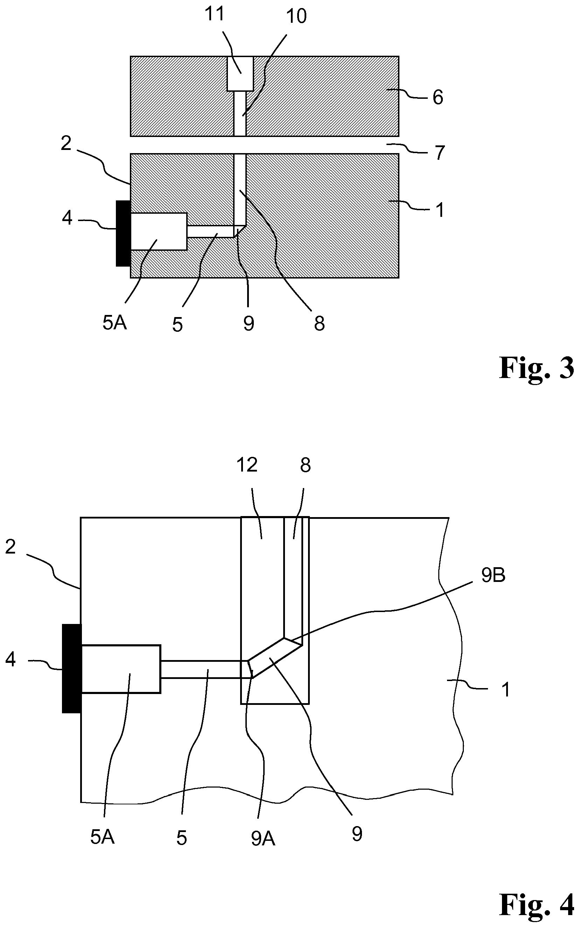

An der Anlagefläche 2 sind mehrere, im gezeigten Beispiel drei in Axialrichtung der Arbeitsspindel 1 verlaufende Kanalabschnitte 5 in Form von Bohrungen vorgesehen, von denen in Fig. 1 jeweils der stirnseitige Austritt aus der Arbeitsspindel 1 sichtbar ist. Fig. 3 zeigt eine schematische Längsschnittansicht eines Ausschnitts der Arbeitsspindel 1 und eines Stators 6, in dem die Arbeitsspindel 1 an einer in Fig. 3 nicht sichtbaren Stelle drehbar gelagert ist, und von dem sie in dem in Fig. 3 sichtbaren Bereich durch einen dünnen Luftspalt 7 getrennt ist. Dort ist nur der obere der drei axialen Kanalabschnitte 5 von Fig. 1 zu sehen. Dieser trifft im Inneren der Arbeitsspindel 1 auf einen in Radialrichtung der Arbeitsspindel 1 verlaufenden Kanalabschnitt 8, wodurch ein dritter Kanalabschnitt 9 definiert wird, in dem der durch die einzelnen Abschnitte 5, 8 und 9 gebildete, durchgehende Kanal seine Richtung um 90° ändert. In gleicher Weise trifft auch jeder der beiden anderen, in Fig. 3 nicht sichtbaren axialen Kanalabschnitte 5 jeweils auf einen zugeordnete radialen Kanalabschnitt 8 in der Arbeitsspindel 1. In der in Fig. 3 gezeigten Winkelstellung der Arbeitsspindel 1 fluchtet der radiale Kanalabschnitt 8 in der Arbeitsspindel 1 mit einem radialen Kanalabschnitt 10 in dem Stator 6.

In einem sich von außen in den Stator 6 erstreckenden Hohlraum ist eine elektronische Messeinrichtung 11 in Form eines Radarsystems, das einen Sender, einen Empfänger und eine Antenne umfasst, angeordnet. Die Antenne ist auf den Kanalabschnitt 10 in dem Stator 6 ausgerichtet, um die Einstrahlung eines Radarsignals in den Kanalabschnitt 10 und den Empfang eines Radarsignals aus dem Kanalabschnitt 10 zu ermöglichen. Der Kanalabschnitt 10 fungiert ebenso wie die Kanalabschnitte 5, 8 und 9 für eine in sie eingestrahlte elektromagnetische Welle als Hohlleiter, wie aus der Radartechnik hinreichend bekannt ist.

In der in Fig. 3 gezeigten Winkelposition der Arbeitsspindel 1 besteht somit insgesamt ein als Hohlleiter wirksamer Kanal 5, 8, 9, 10 zwischen der Messeinrichtung 11 und der rückwärtigen Auflagefläche des Werkzeugs 4, mit dem dieses auf der Auflagefläche 2 der Arbeitsspindel 1 aufliegt. Ein von der Messeinrichtung 11 in den Kanalabschnitt 10 eingestrahltes Radarsignal breitet sich über den Kanalabschnitt 10, den damit fluchtenden Kanalabschnitt 8 und die Kanalabschnitte 9 und 5 bis zu der rückwärtigen Auflagefläche des Werkzeugs 4 aus, wobei es in dem Kanalabschnitt 9 um 90° umgelenkt wird. Dabei führt der Kanal 5, 8, 9, 10 die sich in ihm ausbreitende elektromagnetische Welle im Sinne eines Hohlleiters. An der rückwärtigen Auflagefläche des Werkzeugs 4 wird das Radarsignal reflektiert und läuft in dem Kanal 5, 8, 9, 10 in entgegengesetzter Richtung bis zu der Messeinrichtung 11 zurück, wo es empfangen und verarbeitet wird, um die exakte Lage des Werkzeugs 4 bezüglich der Auflagefläche 2 der Arbeitsspindel 1 zu ermitteln.

Falls der Kanal 5, 8, 9, 10 mit einem Dielektrikum gefüllt ist, ändert sich die Crenzfrequenz, ab welcher der Kanal 5, 8, 9, 10 als Hohlleiter wirksam ist. Es ist äußerst zweckmäßig, den Kanal 5, 8, 9, 10 zumindest im Bereich des werkzeugseitigen Abschnitts 5 mit einem Dielektrikum zu füllen, um ein Eindringen von Schmutz und Spänen, welches die Wellenausbreitung offensichtlich stören würde, zu verhindern. Zur Schaffung homogener Ausbreitungseigenschaften ist es jedoch bevorzugt, den gesamten Kanal 5,8,9,10 mit einem Dielektrikum zu füllen. Geeignet ist hierfür beispielsweise eine Vergussmasse auf Polyurethanbasis.

Zur Erhöhung der Empfindlichkeit ist es zweckmäßig, den Abschnitt 5 so zu gestalten, dass eine möglichst ausgeprägte Resonanz auftritt, was in Fig. 3 durch eine Erweiterung am werkzeugseitigen Ende zu einer Kammer 5A, die zusammen mit der rückwärtigen Oberfläche des Werkzeugs 4 einen Mikrowellenresonator bildet, schematisch dargestellt ist. Hierdurch kann ein Resonator hoher Güte realisiert werden, dessen Resonanzfrequenz von der Lage der rückwärtigen Auflagefläche des Werkzeugs 4 bezüglich der Arbeitsspindel 1 abhängt. Ein solcher Mikrowellenresonator wird bereits bei einer geringfügigen Abweichung der Lage des Werkzeugs 4 von einer perfekten Plananlage an der Auflagefläche 2 der Arbeitsspindel 1 verstimmt, was anhand einer Messung des Reflexionskoeffizienten bei einer Variation der Frequenz des eingestrahlten Signals durch eine in dem Radarsystem 11 enthaltene Signalverarbeitungseinrichtung detektiert werden kann.

Beim Entwurf dieses Mikrowellenresonators muss außer dem Kanal 5,8,9,10 und der Kammer 5A auch der Einfluss des zwischen dem Stator 6 und der rotierenden Arbeitsspindel 1 vorhandenen Luftspalts 7, an dem die Kanalabschnitte 8 und 10 miteinander fluchtend enden, berücksichtigt werden. Bei einer Realisierung der Kanalabschnitte 5, 8 und 10 als Bohrungen entspricht die vorausgehend beschriebene Vorrichtung dem aus der zuvor genannten DE 10 2009 005 745 A1 bekannten Stand der Technik. Wie diese Vorrichtung erfindungsgemäß verbessert werden kann, wird nachfolgend anhand der weiteren Figuren 4 bis 9 erläutert.

Fig.4 zeigt eine Detailansicht eines Ausschnitts aus Fig. 3 mit einer ersten Ausführungsform eines erfindungsgemäßen Einsatzes 12. In einer als axiale Bohrung von der Anlagefläche 2 in der Arbeitsspindel 1 ausgebildeten Kammer 5A ist ein aus keramischem Material bestehender Körper eingefügt, welcher durch den Übergang zu einem ebenfalls als axiale Bohrung in der Arbeitsspindel 1 ausgebildeten Kanalabschnitt 5 mit geringerem Durchmesser in axialer Richtung mechanisch abgestützt wird. Gleichzeitig wird hierdurch die Ankopplung des Mikrowellenresonators an den Wellenleiter eingestellt, über welchen dem Resonator Mikrowellenleistung variabler Frequenz zugeführt und reflektierte Mikrowellenleistung abgeführt wird. Bei diesem Wellenleiter handelt es sich um den sich an die Kammer 5A anschließenden axialen Kanalabschnitt 5, der ebenfalls mit einem Dielektrikum aus vorzugsweise keramischen Material gefüllt ist.

Die den axialen Kanalabschnitt 5 bildende Bohrung trifft im Inneren der Arbeitsspindel 1 auf eine radiale Bohrung in der Arbeitsspindel 1 mit wesentlich größerem Durchmesser, in der ein Einsatz 12 aufgenommen ist. Innerhalb dieses Einsatzes 12 sind ein radialer Kanalabschnitt 8 und ein Kanalabschnitt 9 mit einer Richtungsänderung von 90°, welcher den axialen Kanalabschnitt 5 mit dem radialen Kanalabschnitt 8 verbindet, ausgebildet, wobei das Ende des Kanalabschnitts 9 an der Oberfläche des Einsatzes 12 mit dem Ende des axialen Kanalabschnitts 5 an der Oberfläche der Bohrung, in die der Einsatz 12 eingeführt ist, fluchtet. Die Kanalabschnitte 8 und 9 brauchen somit nicht durch Ausführung von Bohrungen unmittelbar in der Arbeitsspindel 1 realisiert zu werden, sondern sie können in dem Einsatz 12 hergestellt werden, welcher dann zur Vervollständigung eines von der Werkzeuganlagefläche 2 bis zur Mantelfläche der Arbeitsspindel 1 reichenden Kanals nur noch in eine entsprechend große radiale Bohrung in der Arbeitsspindel 1 eingeführt und dort fixiert zu werden braucht.

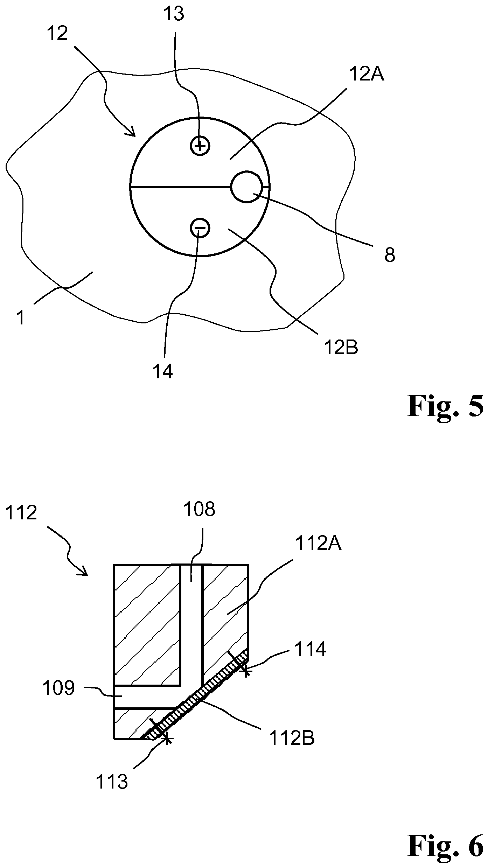

Wie die Draufsicht von Fig. 5 auf einen Ausschnitt der Mantelfläche der Arbeitsspindel 1 zeigt, besteht der Einsatz 12 aus zwei zueinander spiegelsymmetrischen Segmenten 12A und 12B, die jeweils die Form eines Halbzylinders und daher in Fig. 5 eine im wesentlichen halbkreisförmige Kontur haben. In jedem der beiden Segmente 12A und 12B sind symmetrisch zueinander liegende halbkreisförmige Nuten ausgebildet, so dass sich bei einer Zusammenfügung der beiden Segmente 12A und 12B an ihrer Symmetrieebene zu einem ganzen Zylinder in dem Einsatz 12 die Kanalabschnitte 8 und 9 mit jeweils kreisförmigem Querschnitt ergeben, von denen in Fig. 5 nur das Ende des radialen Abschnitts 8 sichtbar ist.

Beide Segmente 12A und 12B werden durch Schrauben 13 bzw. 14 in der Bohrung in der Arbeitsspindel 1 fixiert, wozu entsprechende Bohrungen in jedem Segment 12A und 12B sowie mit diesen fluchtende Gewinde in der Arbeitsspindel 1, die in den Figuren nicht dargestellt sind, erforderlich sind. Auch die innerhalb des Einsatzes 12 liegenden Kanalabschnitte 8 und 9 sind mit einem Dielektrikum aus vorzugsweise keramischem Material ausgefüllt.

Der Übergang des als Wellenleiter wirksamen Kanals 5, 8, 9 zwischen der Axialrichtung und der Radialrichtung der Arbeitsspindel 1 in dem Abschnitt 9 erfolgt bei dem in Fig. 4 dargestellten Ausführungsbeispiel über zwei Richtungsänderungen von jeweils 45° an zwei Knickstellen 9A und 9B. Diese Knickstellen 9A und 9B stellen für die sich im Kanal fortpflanzenden Mikrowellen Störungen dar, die zur Reflexion eines Teils der Mikrowellenleistung führen. Um diese Reflexionen zu minimieren, ist die Änderung der Ausbreitungsrichtung der Mikrowellen im Wellenleiter auf zwei Knickstellen 9A und 9B verteilt und deren gegenseitiger Abstand als ungeradzahliges Vielfaches eines Viertels der Wellenlänge des sich innerhalb des Kanalabschnitts 9 ausbreitenden Signals festgelegt. Hierdurch kommt es zu einer destruktiven Interferenz der an den beiden Knickstellen 9A und 9B reflektierten Anteile der im Wellenleiter geführten Mikrowellenleistung.

Bei der hier vorliegenden Wellenleiterstruktur können aber auch andere Lösungen zur Minimierung von Rückstreuungen bei Änderungen der Ausbreitungsrichtung von sich in einem Wellenleiter fortpflanzenden Wellen angewandt werden. Eine solche Lösung ist die Einfügung einer leitenden Ebene an der Außenseite einer Knickstelle, deren Normalenvektor parallel zur Winkelhalbierenden des von beiden in der Knickstelle verbundenen Wellenleiterabschnitten gebildeten Knickwinkels ist. Eine andere Lösung ist die Ausführung der Richtungsänderung in Form eines Kreisbogens, dessen Radius den Durchmesser des Wellenleiters wesentlich übersteigt.

Der Wellenleiter ist in Fig. 4 und 5 als Hohlleiter dargestellt, was voraussetzt, dass der Einsatz 12 ebenso wie die Arbeitsspindel 1 aus leitfähigem Material wie Metall besteht oder zumindest die in dem Einsatz 12 verlaufenden Kanalabschnitte 8 und 9 an ihrer Oberfläche mit einer leitfähigen Beschichtung versehen sind. Alternativ kann der Wellenleiter aber auch als TEM-Leitung ausgeführt werden. Eine gängige Form einer TEM-Leitung ist ein Koaxialkabel, das in dem Kanal 5, 8, 9 verlegt werden kann. In diesem Fall bietet sich die Ausführung der Richtungsänderung in dem Kanalabschnitt 9 in Form eines Kreisbogens an, um die Verlegung des Kabels in dem Kanal 5, 8, 9 zu erleichtern. Bei Verwendung eines Koaxialkabels braucht die Oberfläche der Kanalabschnitte 8 und 9 nicht leitfähig zu sein, da der Einsatz 12 dann nur als mechanische Halterung für das Koaxialkabel fungiert.

Aufgrund des in solchen Anwendungen geringen Durchmessers eines Koaxialkabels und insbesondere dessen Innenleiters besteht in diesem Fall ein Problem in der verlust- und reflexionsarmen Überwindung des Luftspaltes 7 zwischen der Arbeitsspindel 1 und dem Stator 6. Eine sehr verlustarme Möglichkeit der Überbrückung dieses Luftspaltes 7 besteht in der Platzierung jeweils einer an die zu übertragende Wellenlänge angepassten Schlitzantenne auf der Arbeitsspindel 1 und an dem Stator 6, d.h. an den jeweiligen Enden der Kanalabschnitte 8 und 10 an dem Luftspalt. Die Schmalseiten dieser Schlitzantennen verlaufen in diesem Fall in Axialrichtung der Arbeitsspindel 1, die Langseiten in Umfangsrichtung. Somit besteht für einen größtmöglichen Rotationswinkelbereich die bestmögliche Überlappung der gegenüberliegenden Antennen. Schlitzantennen sind in Fachkreisen als solche bekannt und bedürfen daher hier keiner Erläuterung.

Eine in Fig. 6 schematisch dargestellte alternative Ausführungsform eines Einsatzes 112 besteht aus einem Hauptteil 112A mit zwei zueinander senkrechten, sich im Bereich einer Oberfläche des Hauptteils 112A schneidenden Bohrungen 108 und 109 und einem mit dem Hauptteil 112A fest verbundenen Abschlussteil 112B, welches besagten Bereich des Schnittpunktes der Bohrungen 108 und 109 nach außen abschließt. Die Bohrung 108 stellt einen Kanalabschnitt dar, der dem radialen Kanalabschnitt 8 der ersten Ausführungsform entspricht und die Bohrung 109 stellt einen Kanalabschnitt dar, der dem Kanalabschnitt 9 der ersten Ausführungsform entspricht und eine Richtungsänderung bewirkt. Erst durch die Hinzufügung des Abschlussteils 112B, das im einfachsten Fall gemäß Fig. 6 die Form einer Platte haben und an dem Hauptteil 112A mittels Schrauben 113 und 114 befestigt werden kann, wird bei dieser Ausführungsform Fall ein geschlossener Kanalabschnitt 109 mit einer Richtungsänderung von 90° gebildet, der sich an den radialen Kanalabschnitt 108 anschließt.

Es versteht sich, dass das Hauptteil 112A eine spezielle Form haben muss, um zu gewährleisten, dass der Schnittbereich der beiden Bohrungen 108 und 109 zumindest teilweise außerhalb des Hauptteils 112A liegt, wobei die in Fig. 6 gezeigte Abschrägung nicht die einzige Möglichkeit ist, sondern beispielsweise auch eine Ausnehmung mit einer konkaven Oberfläche vorgesehen sein könnte. Wenn die Kanalabschnitte 108 und 109 als Hohlwellenleiter fungieren, dann muss zumindest die innere Oberfläche des Abschlussteils 112B leitfähig sein, um als Reflexionsfläche zur Umlenkung von sich in den Kanalabschnitten 108 und 109 ausbreitenden elektromagnetischen Wellen zu wirken.

Vor der Montage des Abschlussteils 112B besteht über die dann noch vorhandene Öffnung in dem Bereich, in dem die beiden Bohrungen 108 und 109 aus dem Hauptteil 112A austreten, die Möglichkeit zur Platzierung von Körpern aus dielektrischem Material in den Bohrungen 108 und 109. Insbesondere aber besteht bei Verwendung einer Koaxialleitung als Wellenleiter die Möglichkeit, zwei Leitungsabschnitte in den Bohrungen 108 und 109 im Bereich der Öffnung durch einen Winkelstecker miteinander zu verbinden, um auf diese Weise für eine Umlenkung der Wellenausbreitung um 90° zu sorgen.

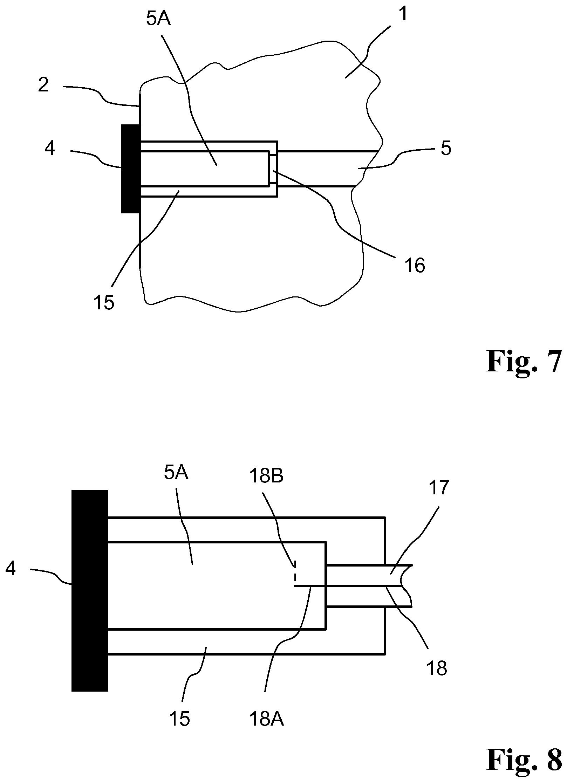

Wie Fig. 7 zeigt, ist auch am anderen Ende des Kanals 5, 8, 9 in der Arbeitsspindel 1, nämlich zur Realisierung der Kammer 5A, die zusammen mit dem Werkzeug 4 einen Mikrowellenresonator bildet, die Verwendung eines Einsatzes 15 von Vorteil. Der Einsatz 15 besteht aus leitfähigem Material, vorzugsweise Metalll und hat die Form eines Bechers mit einer Öffnung 16 im Boden. Der die Kammer 5A bildende Innenraum des Einsatzes 15 ist wie der gesamte Kanal 5, 8, 9 in der Arbeitsspindel 1 mit einem Dielektrikum ausgefüllt. Der Einsatz 15 ist bündig mit der Werkzeuganlagefläche 2 in eine in der Arbeitsspindel 1 eingepasst, deren Durchmesser größer ist als der Durchmesser des sich unmittelbar anschließenden axialen Kanalabschnitts 5. Der Boden des Einsatzes 15 liegt an dem am Übergang von der größeren Bohrung zu dem Kanalabschnitt 5 vorhandenen Absatz an. Hierdurch ist die Ableitung einer beim Kontakt des Einsatzes 15 mit dem Werkzeug 4 in Axialrichtung auf den Einsatz 15 wirkenden Kraft auf die Arbeitsspindel 1 und die Vermeidung einer Belastung eines in dem Kanalabschnitt 5 angeordneten Dielektrikums oder einer dortigen Koaxialleitung gewährleistet.

Fig. 8 zeigt die Ankopplung des durch den Einsatz 15, das in der Kammer 5A vorhandene Dielektrikum und das Werkzeug 4 gebildeten Mikrowellenresonators an eine Koaxialleitung 17. Ein über das Ende der Koaxialleitung 17 hinausragendes kurzes Segment 18A des Innenleiters 18 erstreckt sich in eine mittige axiale Bohrung in dem Dielektrikum in der Kammer 5A, wodurch der Mikrowellenresonator im Betrieb lateral im E01-Mode angeregt wird. Der Außenleiter der Koaxialleitung 17 liegt im Bereich der Öffnung 16 am Boden des becherförmigen Einsatzes 15 an und kontaktiert ihn elektrisch.

Eine Anregung des Mikrowellenresonators im H11-Mode ist ebenfalls möglich. Hierzu weist das Dielektrikum in der Kammer 5A eine von seiner Oberfläche aus radial bis zum Ende der mittigen axialen Bohrung reichende weitere Bohrung auf, in der sich ein mit dem Innenleitersegment 18A elektrisch leitend verbundenes weiteres Leitersegment 18B befindet, das in Fig. 8 gestrichelt dargestellt ist. Das radiale Leitersegment 18B kann auch einstückig mit dem axialen Innenleitersegment 18A ausgebildet sein.

Eine alternative Realisierungsmöglichkeit besteht in der Ausbildung des radialen Leitersegments 18B als Leiterbahn auf einer am Boden des Einsatzes in radialer Richtung angeordneten Leiterplatte. Die Verbindung mit dem axialen Innenleitersegment 18A erfolgt in diesem Fall durch Verlöten des Innenleitersegments 18A mit einer Durchkontaktierung, welche zu dem radialen Leitersegment 18B auf der anderen Seite der Leiterplatte führt. In diesem Fall liegt das radiale Leitersegment 18B nicht innerhalb eines einzigen dielektrischen Körpers, sondern das Dielektrikum in der Kammer 5A ist zweiteilig und besteht aus dem dielektrischen Substrat besagter Leiterplatte und einem zweiten Körper, der den Raum zwischen der Leiterplatte und dem durch das Werkzeug 4 abgeschlossen Ende der Kammer 5A ausfüllt. Die axiale Position des radialen Leitersegments 18B in der Kammer 5A wird folglich durch die Dicke der Leiterplatte bestimmt. Dieser Aufbau ist einfacher herstellbar als die Anordnung eines radialen Leitersegments 18B innerhalb eines einzigen dielektrischen Körpers.

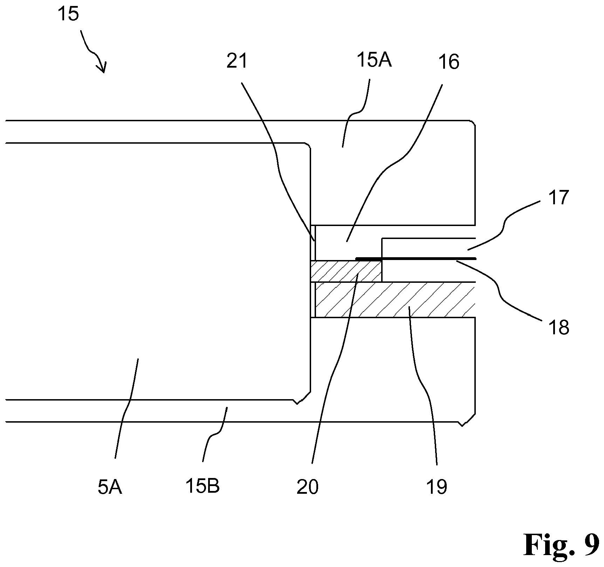

In Fig. 9 ist eine weitere mögliche Variante der Ankopplung einer Koaxialleitung 17 an den Mikrowellenresonator dargestellt. In der Öffnung 16 am Boden 15A des Einsatzes 15 ist ein metallischer Halter 19 in Form eines Zylindersegments angeordnet, der den Außenleiter der Koaxialleitung 17 mit dem Einsatz 15 sowohl mechanisch, als auch elektrisch verbindet, wozu der Boden 15A des Einsatzes 15 eine größere Dicke als dessen Seitenwand 15B hat. Auf der ebenen Oberfläche an der Oberseite des Halters 19, ist ein plattenförmiges dielektrisches Substrat 20 angeordnet, auf dessen dem Halter 19 abgewandter Oberseite sich eine Mikrostreifenleitung befindet, zu der die Oberfläche des Halters 19 eine Massefläche bildet.

Das Ende des Innenleiters 18 der Koaxialleitung 17 ist mit der Mikrostreifenleitung auf dem Substrat 20 verbunden. Am Übergang der Öffnung 16 des Einsatzes 15 zu der Kammer 5A im Inneren des Einsatzes 15 ist eine elektrisch leitfähige Blende 21 angeordnet, in die mittig ein Schlitz eingeschnitten ist, dessen Rand mit der Leiterbahn auf der Oberseite des Substrates 20 verbunden ist. Auch mit dieser Anordnung kann ein Mikrowellensignal von der Koaxialleitung 17 in den Mikrowellenresonator eingekoppelt und ein Reflexionssignal in die Koaxialleitung 17 zurückgekoppelt werden.

Auf die Funktionsweise der Messeinrichtung 11 wurde in der vorausgehenden Beschreibung nicht im einzelnen eingegangen, da hierzu in der eingangs genannten DE 10 2009 005 745 A1 detaillierte Angaben vorhanden sind, auf die hiermit verwiesen wird. Diese Angaben beziehen sich zwar auf den Einsatz eines Radarsystems als Messeinrichtung 11 und setzen daher eine Wirkung des Kanals 5, 8, 9, 10 als Hohlwellenleiter für ein Radarsignal voraus. Wenn in dem Kanal 5, 8, 9, 10 stattdessen als Wellenleiter eine Koaxialleitung verlegt ist, ändert sich lediglich die Ankopplung der Messeinrichtung 11 an den Wellenleiter, für die in diesem Fall keine Antenne mehr benötigt wird, während das Funktionsprinzip der Reflexionsmessung aber dasselbe bleibt. Der korrekte Anschluss einer Koaxialleitung an eine Reflexionsmesseinrichtung ist in Fachkreisen bekannt und bedarf daher an dieser Stelle keiner Erläuterung.

## Patentansprüche

1. Vorrichtung zur Überwachung der Lage eines Werkzeugs (4) oder Werkzeugträgers an einer Arbeitsspindel (1), insbesondere in einer Bearbeitungsmaschine, wobei die Arbeitsspindel (1) mindestens einen von einer äußeren Oberfläche der Arbeitsspindel (1) zu dem Werkzeug (4) oder Werkzeugträger führenden Kanal (5, 8, 9) aufweist, der einen Pfad für die Ausbreitung eines elektromagnetischen Signals bildet, und wobei außerhalb der Arbeitsspindel (1) eine Messeinrichtung (11) angeordnet ist, welche eine Sendeeinheit zur Einkopplung eines elektromagnetischen Signals in den Kanal (5, 8, 9), eine Empfangseinheit zum Empfang eines aus dem Kanal (5, 8, 9) reflektierten Signals und eine Signalverarbeitungseinrichtung zur Ermittlung eines Maßes für die Lage des Werkzeugs (4) oder Werkzeughalters in Bezug auf die Arbeitsspindel (1) anhand des reflektierten Signals enthält, **dadurch gekennzeichnet, dass** an mindestens einem der zwei Enden des Kanals (5, 8, 9) in der Arbeitsspindel (1) ein Einsatz (12; 112; 15) angeordnet ist, welcher die Form eines Abschnitts (8, 9; 108, 109; 5A) des Kanals (5, 8, 9) definiert.

2. Vorrichtung nach Anspruch 1, **dadurch gekennzeichnet, dass** der Einsatz (12; 112; 15) aus leitfähigem Material besteht oder zumindest eine leitfähige innere Oberfläche, welche die Oberfläche des von ihm definierten Abschnitts des Kanals (5, 8, 9) bildet, aufweist.

3. Vorrichtung nach Anspruch 1 oder 2, **dadurch gekennzeichnet, dass** der Kanal (5, 8, 9) einen an der äußeren Oberfläche der Arbeitsspindel (1) endenden ersten Abschnitt (8; 108) mit einer radialen Richtungskomponente bezüglich der Achse der Arbeitsspindel (1), einen an dem Werkzeug (4) oder Werkzeugträger endenden zweiten Abschnitt (5) mit einer axialen Richtungskomponente bezüglich der Achse der Arbeitsspindel (1) und einen zwischen dem ersten und dem zweiten Abschnitt liegenden dritten Abschnitt (9; 109) mit einer Richtungsänderung aufweist, und dass der der erste Abschnitt (8; 108) und der dritte Abschnitt (9; 109) in dem Einsatz (12; 112) ausgebildet sind.

4. Vorrichtung nach Anspruch 3, **dadurch gekennzeichnet, dass** die Richtungsänderung in dem dritten Abschnitt (9; 109) in Form einer oder mehrerer abrupter Richtungsänderungen (9A, 9B) oder in Form einer kontinuierlichen Richtungsänderung, deren Krümmungsradius wesentlich größer als der Durchmesser des Kanalabschnitts (9; 109) ist, erfolgt.

5. Vorrichtung nach einem der Ansprüche 1 bis 4, **dadurch gekennzeichnet, dass** ein Einsatz (12) aus zwei Segmenten (12A, 12B) besteht, die sich in einer Ebene in flächigem Kontakt miteinander befinden, und dass der Abschnitt (8, 9) des Kanals in dem Einsatz (12) durch zueinander symmetrische Nuten in den beiden Segmenten gebildet wird.

6. Vorrichtung nach Anspruch 3 oder 4, **dadurch gekennzeichnet, dass** der Einsatz (112) ein Hauptteil (112A) mit zwei sich schneidenden Durchgangsbohrungen (108, 109) unterschiedlicher Richtungen, die jeweils Abschnitte (108, 109) des Kanals (5, 8, 9) bilden und deren Schnittbereich sich zumindest teilweise außerhalb des Hauptteils (112A) erstreckt, und ein Abschlussteil (112B), welches den Schnittbereich der Durchgangsbohrungen (108, 109) nach außen abschließt und dadurch den dritten Abschnitt (109) des Kanals (5, 8, 9) mit der Richtungsänderung vervollständigt, aufweist.

7. Vorrichtung nach Anspruch 6, **dadurch gekennzeichnet, dass** in dem Kanal (5, 8, 9) eine Koaxialleitung angeordnet ist, und dass das Abschlussteil (112B) einen Winkelstecker enthält, der zwei Abschnitte verschiedener Richtungen dieser Koaxialleitung (17) miteinander verbindet.

8. Vorrichtung nach einem der Ansprüche 1 bis 7, **dadurch gekennzeichnet, dass** ein sich bis zu dem Werkzeug (4) oder Werkzeugträger erstreckender Endabschnitt (5A) des Kanals (5, 8, 9), welcher zusammen mit einer Oberfläche des Werkzeugs (4) oder Werkzeugträgers einen Mikrowellenresonator mit einer vom Abstand der Oberfläche des Werkzeugs (4) oder Werkzeugträgers vom Ende des Endabschnitts (5A) abhängigen Resonanzfrequenz bildet, in einem Einsatz (15) ausgebildet ist.

9. Vorrichtung nach Anspruch 8, **dadurch gekennzeichnet, dass** der Einsatz (15) ein leitfähiger becherförmiger Körper ist, dessen Rand dem Werkzeug (4) oder Werkzeugträger zugewandt ist, dessen Boden eine Öffnung (16) aufweist und dessen Außendurchmesser größer ist als der Durchmesser des sich an die Öffnung (16) in dem Boden anschließenden Abschnitts (5) des Kanals (5, 8, 9).

10. Vorrichtung nach Anspruch 8 oder 9, **dadurch gekennzeichnet, dass** der in dem Einsatz (15) ausgebildete Endabschnitt (5A) des Kanals (5, 8, 9) durch mindestens ein Dielektrikum ausgefüllt ist, und dass in dem sich an den Einsatz (15) anschließenden Abschnitt (5) des Kanals (5, 8, 9) eine Koaxialleitung (17) angeordnet ist, deren Außenleiter mit dem Einsatz (15) verbunden ist und dessen Innenleiter (18) ein Segment (18A) aufweist, welches sich um ein vorbestimmtes Ausmaß axial in den Endabschnitt (5A) hinein erstreckt.

11. Vorrichtung nach Anspruch 10, **dadurch gekennzeichnet, dass** am Ende des sichaxial in den Endabschnitt (5A) des Kanals (5, 8, 9) erstreckenden Innenleitersegments (18A) ein sich in radialer Richtung erstreckendes Leitersegment (18B) vorgesehen ist, welches mit dem sich axial erstreckenden Innenleitersegment (18A) elektrisch verbunden oder einstückig mit diesem ausgebildet ist.

12. Vorrichtung nach Anspruch 11, **dadurch gekennzeichnet, dass** das sich in radialer Richtung erstreckende Leitersegment (18B) durch eine Leiterbahn auf einer Leiterplatte gebildet wird und über eine Durchkontaktierung mit dem sich axial erstreckenden Innenleitersegment (18A) elektrisch verbunden ist, und dass das Dielektrikum in dem Endabschnitt (5A) aus dem dielektrischen Substrat der Leiterplatte und einem zweiten dielektrischen Körper besteht.

13. Vorrichtung nach Anspruch 8 oder 9, **dadurch gekennzeichnet, dass** die dem sich an den Einsatz (15) anschließenden Abschnitt (5) des Kanals (5, 8, 9) zugewandte Seite des Einsatzes (15) durch eine Blende (20) aus leitfähigem Material mit einem Schlitz abgeschlossen ist, die über eine Mikrostreifenleitung mit dem Innenleiter (18) einer in dem sich an den Einsatz (15) anschließenden Abschnitt (5) des Kanals (5, 8, 9) angeordneten Koaxialleitung (17) verbunden ist, deren Außenleiter mit der Massefläche der Mikrostreifenleitung und mit dem Einsatz (15) verbunden ist.

## Claims

1. Device for monitoring the position of a tool (4) or tool holder on a work spindle (1), in particular in a machine tool, wherein the work spindle (1) has at least one channel (5, 8, 9) running from an outer surface of the work spindle (1) to the tool (4) or tool holder, which channel forms a path for the propagation of an electromagnetic signal, and wherein a measuring device (11) is arranged outside the work spindle (1), which measuring device comprises a transmitting unit for transmitting an electromagnetic signal into the channel (5, 8, 9), a receiving unit for receiving a reflected signal from the channel (5, 8, 9), and a signal processing device for determining a measurement for the position of the tool (4) or tool holder with respect to the work spindle (1) by reference to the reflected signal, **characterised in that** an insert (12; 112; 15) is arranged at least at one of the two ends of the channel (5, 8, 9) in the work spindle (1), which insert defines the form of a portion (8, 9; 108, 109; 5A) of the channel (5, 8, 9).

2. Device according to claim 1, **characterised in that** the insert (12; 112; 15) is made of conductive material or has at least one conductive inner surface which forms the surface of the portion of the channel (5, 8, 9) defined by it.

3. Device according to claim 1 or 2, **characterised in that** the channel (5, 8, 9) has a first portion (8; 108) ending at the outer surface of the work spindle (1) and having a radial directional component with respect to the axis of the work spindle (1), a second portion (5) ending at the tool (4) or tool holder and having an axial directional component with respect to the axis of the work spindle (1), and a third portion (9; 109) lying between the first and the second portion and having a change of direction, and **in that** the first portion (8; 108) and the third portion (9; 109) are formed in the insert (12; 112).

4. Device according to claim 3, **characterised in that** the change of direction in the third portion (9; 109) is effected in the form of one or more abrupt changes of direction (9A, 9B) or in the form of a continuous change of direction, the radius of curvature of which is substantially greater than the diameter of the channel portion (9; 109).

5. Device according to one of claims 1 to 4, **characterised in that** an insert (12) consists of two segments (12A, 12B) which are in areal contact with one another in one plane, and **in that** the portion (8, 9) of the channel in the insert (12) is formed by grooves which are symmetrical to one another in the two segments.

6. Device according to claim 3 or 4, **characterised in that** the insert (112) has a main part (112A) with two intersecting through-bores (108, 109) extending in different directions which each form portions (108, 109) of the channel (5, 8, 9) and the region of intersection of which extends at least partly outside the main part (112A), and a closing part (112B) which closes the region of intersection of the through-bores (108, 109) to the exterior and thereby completes the third portion (109) of the channel (5, 8, 9) with the change of direction.

7. Device according to claim 6, **characterised in that** a coaxial line is arranged in the channel (5, 8, 9), and **in that** the closing part (112B) comprises an angled connector which connects two portions of this coaxial line (17) extending in different directions with one another.

8. Device according to one of claims 1 to 7, **characterised in that** an end portion (5A) of the channel (5, 8, 9) which extends as far as the tool (4) or tool holder and together with a surface of the tool (4) or tool holder forms a microwave resonator with a resonance frequency dependent on the distance of the surface of the tool (4) or tool holder from the end of the end portion (5A), is formed in an insert (15).

9. Device according to claim 8, **characterised in that** the insert (15) is a conductive cup-shaped body, the rim of which faces the tool (4) or tool holder, the bottom of which has an opening (16) and the outside diameter of which is greater than the diameter of the portion (5) of the channel (5, 8, 9) adjacent to the opening (16) in the bottom.

10. Device according to claim 8 or 9, **characterised in that** the end portion (5A) of the channel (5, 8, 9) formed in the insert (15) is filled by at least one dielectric, and **in that** a coaxial line (17) is arranged in the portion (5) of the channel (5, 8, 9) adjacent to the insert (15), the outer conductor of said coaxial line being connected with the insert (15) and its inner conductor (18) having a segment (18A) which extends axially into the end portion (5A) by a predetermined amount.

11. Device according to claim 10, **characterised in that** at the end of the inner conductor segment (18A) extending axially into the end portion (5A) of the channel (5, 8, 9) there is a conductor segment (18B) which extends in a radial direction and is embodied so as to be connected electrically with the axially extending inner conductor segment (18A) or formed in one piece with the latter.

12. Device according to claim 11, **characterised in that** the conductor segment (18B) extending in a radial direction is formed by a conductor track on a printed circuit board and is connected electrically with the axially extending inner conductor segment (18A) by means of through-plating, and **in that** the dielectric in the end portion (5A) consists of the dielectric substrate of the printed circuit board and a second dielectric body.

13. Device according claim 8 or 9, **characterised in that** the side of the insert (15) facing the portion (5) of the channel (5, 8, 9) adjacent to the insert (15) is closed by a plate (20) made of conductive material with a slit, which plate is connected by means of a micro strip line with the inner conductor (18) of a coaxial line (17) arranged in the portion (5) of the channel (5, 8, 9) adjacent to the insert (15), the outer conductor of the coaxial line being connected with the ground face of the micro strip line and with the insert (15).

## Revendications

1. Dispositif servant à surveiller la position d'un outil (4) ou d'un support d'outil au niveau d'une broche de travail (1), en particulier dans une machine d'usinage, dans lequel la broche de travail (1) présente au moins un canal (5, 8, 9) menant depuis une surface extérieure de la broche de travail (1) à l'outil (4) ou au support d'outil, lequel canal forme un chemin pour la propagation d'un signal électromagnétique, et dans lequel est disposé, à l'extérieur de la broche de travail (1), un système de mesure (11), qui contient une unité d'émission servant à injecter un signal électromagnétique dans le canal (5, 8, 9), une unité de réception servant à recevoir un signal réfléchi hors du canal (5, 8, 9) et un système de traitement de signaux servant à déterminer une mesure pour la position de l'outil (4) ou du support d'outil par rapport à la broche de travail (1) à l'aide du signal réfléchi, **caractérisé en ce qu'**est disposé, au niveau au moins d'une des deux extrémités du canal (5, 8, 9) dans la broche de travail (1), un insert (12 ; 112 ; 15), qui définit la forme d'un tronçon (8, 9 ; 108, 109 ; 5A) du canal (5, 8, 9).

2. Dispositif selon la revendication 1, **caractérisé en ce que** l'insert (12 ; 112 ; 15) est constitué d'un matériau conducteur ou présente au moins une surface intérieure conductrice, qui forme la surface du tronçon, défini par l'insert, du canal (5, 8, 9).

3. Dispositif selon la revendication 1 ou 2, **caractérisé en ce que** le canal (5, 8, 9) présente un premier tronçon (8 ; 108) se terminant au niveau de la surface extérieure de la broche de travail (1), pourvu d'un composant de direction radial par rapport à l'axe de la broche de travail (1), un deuxième tronçon (5) se terminant au niveau de l'outil (4) ou du support d'outil, pourvu d'un composant de direction axial par rapport à l'axe de la broche de travail (1) et un troisième tronçon (9 ; 109) situé entre le premier et le deuxième tronçon, pourvu d'un changement de direction, et **en ce que** le premier tronçon (8 ; 108) et le troisième tronçon (9 ; 109) sont réalisés dans l'insert (12 ; 112).

4. Dispositif selon la revendication 3, **caractérisé en ce que** le changement de direction a lieu dans le troisième tronçon (9 ; 109) sous la forme d'un ou de plusieurs changements de direction (9A, 9B) abruptes ou sous la forme d'un changement de direction continu, dont le rayon de courbure est sensiblement plus grand que le diamètre du tronçon de canal (9 ; 109).

5. Dispositif selon l'une quelconque des revendications 1 à 4, **caractérisé en ce qu'**un insert (12) est constitué de deux segments (12A, 12B), qui se trouvent en contact l'un avec l'autre à plat dans un plan, et **en ce que** le tronçon (8, 9) du canal dans l'insert (12) est formé par des rainures symétriques les unes par rapport aux autres dans les deux segments.

6. Dispositif selon la revendication 3 ou 4, **caractérisé en ce que** l'insert (112) présente une partie principale (112A) pourvue de deux alésages de passage (108, 109) se coupant en des directions différentes, lesquels forment respectivement des tronçons (108, 109) du canal (5, 8, 9) et dont la plage d'intersection s'étend au moins en partie à l'extérieur de la partie principale (112A), et une partie de fermeture (112B), qui ferme vers l'extérieur la plage d'intersection des alésages de passage (108, 109) et complète ce faisant le troisième tronçon (109) du canal (5, 8, 9) présentant le changement de direction.

7. Dispositif selon la revendication 6, **caractérisé en ce qu'**une ligne coaxiale est disposée dans le canal (5, 8, 9), et **en ce que** la partie de fermeture (112B) contient un connecteur coudé, qui relie deux tronçons de directions différents de ladite ligne coaxiale (17).

8. Dispositif selon l'une quelconque des revendications 1 à 7, **caractérisé en ce qu'**un tronçon d'extrémité (5A), s'étendant jusqu'à l'outil (4) ou jusqu'au support d'outil, du canal (5, 8, 9), lequel forme, conjointement avec une surface de l'outil (4) ou du support d'outil, un résonateur à micro-ondes présentant une fréquence de résonance dépendant de la distance de la surface de l'outil (4) ou du support d'outil par rapport à l'extrémité du tronçon d'extrémité (5A), est réalisé dans un insert (15).

9. Dispositif selon la revendication 8, **caractérisé en ce que** l'insert (15) est un corps conducteur en forme de pot, dont le bord est tourné vers l'outil (4) ou le support d'outil, dont le fond présent une ouverture (16) et dont le diamètre extérieur est plus grand que le diamètre du tronçon (5) se raccordant à l'ouverture (16) dans le fond.

10. Dispositif selon la revendication 8 ou 9, **caractérisé en ce que** le tronçon d'extrémité (5A) réalisé dans l'insert (15), du canal (5, 8, 9) est rempli par au moins un diélectrique, et **en ce qu'**est disposée, dans le tronçon (5), se raccordant à l'insert (15), du canal (5, 8, 9), une ligne coaxiale (17), dont le conducteur extérieur est relié à l'insert (15) et dont le conducteur intérieur (18) présente un segment (18A), qui s'étend à l'intérieur du tronçon d'extrémité (5A) selon une dimension prédéterminée.

11. Dispositif selon la revendication 10, **caractérisé en ce qu'**est prévu, au niveau de l'extrémité du segment de conducteur intérieur (18A) s'étendant de manière axiale dans le segment d'extrémité (5A) du canal (5, 8, 9), un segment de conducteur (18B) s'étendant dans une direction radiale, lequel est relié de manière électrique au segment de conducteur intérieur (18A) s'étendant de manière axiale ou qui est réalisé d'un seul tenant avec ce dernier.

12. Dispositif selon la revendication 11, **caractérisé en ce que** le segment de conducteur (18B) s'étendant dans une direction radiale est formé par un tracé conducteur sur une carte de circuits imprimés et est relié de manière électrique au segment de conducteur intérieur (18A) s'étendant de manière axiale par l'intermédiaire d'un contact traversant, et **en ce que** le diélectrique dans le tronçon d'extrémité (5A) est constitué du substrat diélectrique de la carte de circuits imprimés et d'un deuxième corps diélectrique.

13. Dispositif selon la revendication 8 ou 9, **caractérisé en ce que** le côté, tourné vers le tronçon (5), se raccordant à l'insert (15), du canal (5, 8, 9), de l'insert (15) est fermé par un cache (20) composé d'un matériau conducteur, pourvu d'une entaille, qui est reliée, par l'intermédiaire d'une ligne microbande, au conducteur intérieur (18) d'une ligne coaxiale (17) disposée dans le tronçon (5), se raccordant à l'insert (15), du canal (5, 8, 9), dont le conducteur extérieur est relié à la surface de masse de la ligne microbande et à l'insert (15).
